(19) Europäisches Patentamt
European Patent Office
Office européen des brevets

(11) **EP 1 553 812 A2**

(12) **DEMANDE DE BREVET EUROPEEN**

(43) Date de publication:
**13.07.2005 Bulletin 2005/28**

(51) Int Cl.[7]: **H05K 1/02**, H01L 23/552, H01L 23/522, H01L 23/498

(21) Numéro de dépôt: **04292385.4**

(22) Date de dépôt: **07.10.2004**

(84) Etats contractants désignés:
**AT BE BG CH CY CZ DE DK EE ES FI FR GB GR HU IE IT LI LU MC NL PL PT RO SE SI SK TR**
Etats d'extension désignés:
**AL HR LT LV MK**

(30) Priorité: **11.12.2003 FR 0314532**

(71) Demandeur: **STMicroelectronics S.A.**
**92120 Montrouge (FR)**

(72) Inventeur: **Grange, Sébastien**
**38600 Fontaine (FR)**

(74) Mandataire: **Verdure, Stéphane**
**Cabinet Plasseraud**
**65/67 rue de la Victoire**
**75440 Paris Cedex 09 (FR)**

(54) **Puce à semiconducteur et circuit comprenant une inductance blindée**

(57)     Circuit à puce (1;1';11) comportant une puce (2; 2';12) qui comporte un substrat semi-conducteur, des composants sensiblement plans formés sur le substrat parmi lesquels figurent un composant émetteur apte à émettre des rayonnements électromagnétique et une inductance (3;3';14) sensible à des rayonnements élec-tromagnétiques incidents. Au moins un écran de blinda-ge (6;6';13), extérieur à la puce, est disposé en regard de l'inductance à une distance inférieure à 500 micro-mètres. L'écran permet ainsi d'assurer un blindage de l'inductance sensible vis-à-vis du composant émetteur en préservant le facteur de qualité de l'inductance.

FIG. 1

EP 1 553 812 A2

## Description

La présente invention concerne les circuits à puce, dans lesquels la puce comporte au moins un substrat semi-conducteur et une inductance sensiblement plane formée sur ce substrat.

Les progrès importants de la microélectronique permettent l'intégration de plus en plus de fonctions sur une seule puce. Cette intégration accrue présente de nombreux avantages, parmi lesquels la réduction de nombre de composants externes et la diminution de la surface occupée.

Ainsi, des puces intègrent des chaînes de transmission RF (RadioFréquence) complètes, pouvant inclure des oscillateurs-traducteurs de tension (VCO, « Voltage Controlled Oscillator »), des boucles à verrouillage de phase (PLL, « Phase-Lock Loop »), des mélangeurs, des préamplificateurs de puissance etc.

L'intégration de nombreux composants sur un même substrat présente toutefois des inconvénients. Elle provoque, notamment à haute fréquence, des couplages de signaux parasites perturbant certaines des fonctions de la puce, par exemple le VCO. Ces signaux parasites sont des signaux générés par des éléments de la puce qui perturbent d'autres éléments de cette même puce. La pénétration de tels signaux parasites à l'intérieur d'un VCO à sa fréquence d'oscillation est généralement appelée « VCO pulling ». Le VCO pulling se traduit notamment par un signal parasite de fréquence égale à l'harmonique n°2 (H2) de la fréquence de fonctionnement. Des éléments particulièrement sensibles, et par conséquent particulièrement victimes de telles perturbations, sont les inductances intégrées dans les puces.

Les conséquences de ce phénomène de parasitage au sein d'une puce sont multiples et peuvent comprendre, par exemple dans le cas du VCO, la production de raies parasites, la modulation de la fréquence de fonctionnement du VCO, la dégradation de l'erreur de phase ou encore l'oscillation du VCO à une fréquence autre que celle souhaitée.

On connaît différents moyens permettant de pallier ces inconvénients. Certains portent sur l'amélioration de la linéarité des blocs générateurs de signaux parasites à H2 ; cette meilleure linéarité peut être obtenue par une alimentation de ces blocs avec un courant plus fort. D'autres prévoient une augmentation du signal utile du VCO (à la fréquence H1) par rapport au signal perturbateur en augmentant le courant consommé par le VCO. Cependant ces solutions impliquent un accroissement de la consommation électrique.

Le document US-A-2002/0180538 décrit une architecture de VCO permettant de réduire les effets de « VCO pulling » en utilisant deux signaux à des fréquences telles que la somme des fréquences est égale à la fréquence de sortie désirée, tout en supprimant des effets parasites. Cependant, cette solution met en oeuvre des composants supplémentaires et est relativement complexe à mettre en oeuvre.

Par ailleurs, le document US-B-6611041 décrit un circuit intégré comprenant une inductance sensiblement plane et un écran de blindage parallèle au plan de l'inductance et faisant face à cette dernière, formé au sein du silicium. La forme de l'écran vise à empêcher toute circulation de courant dans l'écran et donc tout champ magnétique qui serait ainsi généré. Un tel écran constitue donc principalement un écran aux parasites électriques. Il permet également d'optimiser le coefficient de qualité de l'inductance en réduisant les pertes résistives vers le substrat. Il nécessite cependant l'intégration d'un élément supplémentaire dans le substrat et accroît la complexité de la puce. De plus, il ne constitue pas un écran aux parasites magnétiques.

D'autre part, on connaît aussi dans l'art antérieur des écrans de blindage situés à l'extérieur d'une puce d'un circuit intégré, pour protéger la puce ou le circuit intégré de perturbations extérieures. Ces écrans sont en général disposés à l'extérieur du boîtier contenant la puce et situés sur la carte électronique pour blinder les circuits réputés sensibles et les circuits réputés perturbateurs. Ils sont situés notamment à distance des inductances de puce, dans le but de ne pas modifier le champ magnétique des inductances et de ne pas dégrader leur facteur de qualité. Pour ce faire, ces écrans sont disposés à plus de 500 micromètres (μm) de l'inductance.

Par ailleurs, le brevet US 6,486,534 décrit un circuit intégré comprenant un premier circuit et au moins un second circuit dans lequel une cage de Faraday comprenant des vias et un plan de masse au sein du substrat est disposée autour du premier circuit pour protéger le second circuit des interférences électromagnétiques produites par le premier circuit (colonne 2 lignes 14-18). Ainsi pour protéger un élément sensible, par exemple une inductance d'un VCO, d'éléments perturbateurs, l'enseignement dispensé par ce document conduit à disposer une ou plusieurs cages de Faraday autour des éléments perturbateurs. Cependant cela implique de ne pas en oublier. D'autre part, cette solution est coûteuse. Par ailleurs, en mettant en oeuvre cette solution, l'élément sensible n'est pas protégé d'un élément perturbateur externe non prévisible, par exemple, le doigt d'un utilisateur se rapprochant du VCO.

La présente invention vise à proposer un circuit à puce comportant au moins une puce présentant un blindage pour l'inductance de la puce qui soit moins affecté par les limitations de l'art antérieur.

A cet effet, l'invention propose un circuit à puce comportant une puce. Cette puce comprend au moins un substrat semi-conducteur et des composants sensiblement plans, formés sur le substrat. Parmi ces composants figure au moins un composant émetteur de rayonnements électromagnétiques et une inductance sensible à des rayonnements électromagnétiques incidents, que l'on souhaite protéger de ces rayonnements. Le circuit à puce comporte au moins un premier écran de blindage extérieur à la puce, s'étendant parallèlement au plan de l'inductance sensible , disposé en regard de ladite inductance sensible à une distance inférieure à 500 µm. Cet écran de blindage, permet ainsi d'assurer un blindage de l'inductance sensible vis-à-vis du ou des composants émetteurs, tout en permettant de préserver le facteur qualité de l'inductance.

Un tel écran de blindage est peu coûteux et ne nécessite pas l'intégration de fonctions électroniques supplémentaires dans la puce. De plus, il constitue non seulement un écran de blindage contre les champs électriques, mais également contre les champs magnétiques. Il est particulièrement avantageux en champ proche, c'est-à-dire adapté au cas de blocs électroniques perturbateurs et de blocs électroniques perturbés séparés d'une distance inférieure à λ/2π, où λ est la longueur d'onde du champ électromagnétique considéré, ce qui est généralement le cas pour des blocs électroniques situés dans la même puce. Il permet en outre de protéger l'inductance d'éléments perturbateurs non prévus, tel qu'un doigt d'un utilisateur.

Avantageusement, la distance entre le plan de l'inductance et le premier écran de blindage est supérieure ou égale à 100 µm.

Dans un mode de réalisation particulièrement efficace, la distance entre l'inductance sensible et le composant émetteur est supérieure à 1 mm (millimètre).

Afin de permettre un blindage accru contre les parasites, la projection orthogonale du premier écran de blindage sur le plan de l'inductance à protéger inclut entièrement l'inductance. Avantageusement, la projection orthogonale du premier écran de blindage sur le plan de l'inductance dépasse un des bords au moins de l'inductance sur une distance de 150 microns minimum.

Dans un mode de réalisation, la puce s'étend parallèlement à un premier support, la distance de la puce au premier support étant déterminée par le diamètre d'un premier type de "bumps" (billes de soudure) utilisés pour relier électriquement la puce au premier support, le premier écran de blindage étant réalisé dans le premier support.

Dans un mode de réalisation, un second écran de blindage s'étend parallèlement au plan de l'inductance et est disposé en regard de l'inductance à protéger à une distance comprise entre 100 et 500 µm, les premier et second écrans de blindage se trouvant de part et d'autre de l'inductance.

Dans un mode de réalisation, le circuit à puce comporte en outre un second support parallèle au premier support, les premier et second supports étant situés de part et d'autre de la puce. La distance de la puce au second support est déterminée par le diamètre d'un second type de "bumps" utilisés pour relier électriquement le premier support au second support. Et le second écran de blindage est réalisé dans le second support.

Dans un mode de réalisation, le circuit à puce comporte en outre un second écran de blindage s'étendant parallèlement au plan de l'inductance et disposé en regard de l'inductance, les premier et second écrans de blindage se trouvant de part et d'autre de l'inductance. Le second écran a une forme annulaire et sa projection orthogonale sur le plan de l'inductance entoure cette dernière.

Avantageusement, la distance entre le plan de l'inductance et le second écran de blindage est inférieure ou égale à 30 µm.

Avantageusement, la projection orthogonale du second écran de blindage sur le plan de l'inductance dépasse au moins un des bords de l'inductance sur une distance de 0,25 mm.

Dans un mode de réalisation, le second écran de blindage est formé sur le substrat de la puce.

Dans un mode de réalisation, la puce comprend un VCO, et l'inductance sensible est un élément du VCO.

D'autres caractéristiques et avantages de l'invention apparaîtront encore à la lecture de la description qui va suivre. Celle-ci est purement illustrative et doit être lue en regard des dessins annexés sur lesquels :

- la figure 1 représente un circuit à puce dans un premier mode de réalisation de l'invention ;
- la figure 2 représente la projection orthogonale d'un écran de blindage du circuit à puce de la figure 1 sur le plan de l'inductance ;
- la figure 3 représente un circuit à puce selon l'invention correspondant à des simulations effectuées ;
- la figure 4a est un diagramme représentant l'atténuation apportée par le circuit à puce de la figure 1 sur le champ magnétique parasite dû au couplage entre deux inductances intégrées sur la même puce, en fonction de la distance entre ces deux inductances ;
- la figure 4b est un diagramme représentant l'atténuation apportée par le circuit à puce de la figure 1 sur le champ magnétique parasite dû au couplage entre deux inductances intégrées sur la même puce, en fonction de la distance entre le plan de l'inductance protégée et les plans de blindage dans un mode de réalisation de l'invention ;
- la figure 5 représente un circuit à puce dans un deuxième mode de réalisation de l'invention ;
- la figure 6 représente une vue de dessus de la figure 5 ;
- la figure 7 représente un circuit à puce dans un troisième mode de réalisation de l'invention ;
- les figures 8a et 8b comportent deux tableaux illustrant les atténuations apportées aux parasites, à la fréquence H2, par les circuits à puce selon l'invention représentés respectivement en figure 5 et en figure 7 ;
- la figure 9 représente la configuration retenue pour établir les tableaux des figures 8a et 8b.

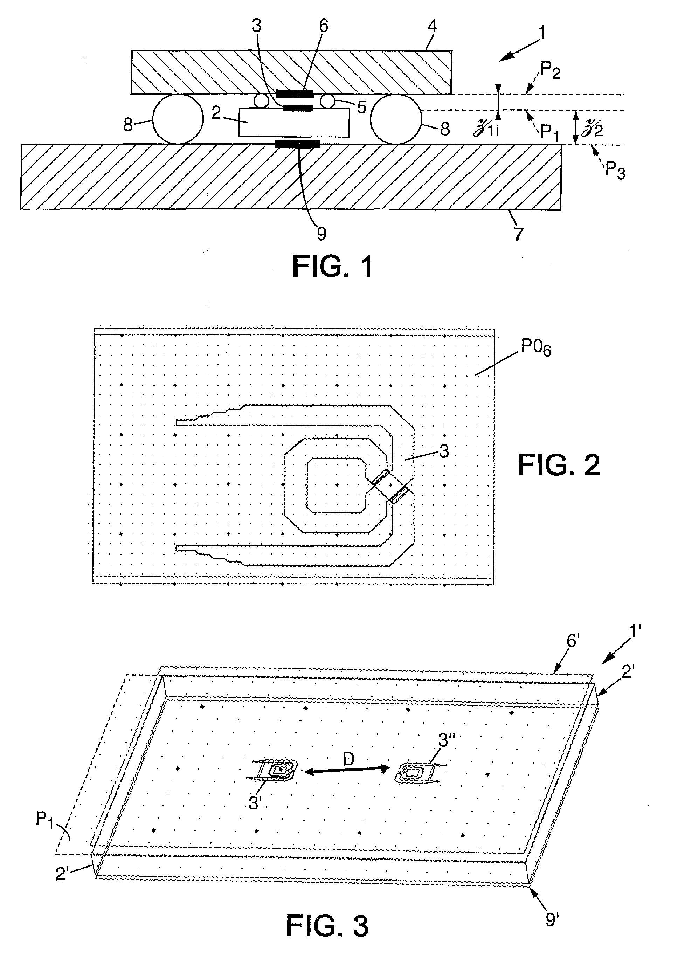

Sur la figure 1 est représenté un circuit à puce 1 dans un mode de réalisation de l'invention. Le circuit à puce 1 comprend au moins une puce 2. La puce 2 comporte un substrat semi-conducteur sur lequel divers composants sont formés. Dans cette puce 2 est intégré notamment un VCO comportant une inductance 3 sensiblement plane formée sur le substrat et s'étendant dans un plan P1.

L'inductance 3 du VCO se comporte comme une antenne réceptrice sensible aux champs électromagnétiques ambiants.

L'inductance 3 intercepte donc les lignes de champs électromagnétiques générées notamment par d'autres composants intégrés sur la puce qui se comportent vis-à-vis de l'inductance 3 à protéger comme des composants perturbateurs, ce qui introduit des courants et tensions parasites dans l'inductance 3, et donc dans le VCO.

Le circuit à puce 1 comporte en outre un support 4 sur lequel la puce 2 est fixée. Le support 4 est dans le cas ici décrit un boîtier de type BGA (de l'anglais "Ball Grid Array", qui signifie boîtier à billes) assemblé à la puce par des billes de soudure 5 ou "bumps" 5, reliant électriquement la puce au boîtier BGA 4. La puce 2 s'étend parallèlement au boîtier BGA 4 et la distance de la puce au boîtier 4 est déterminée par le diamètre des bumps 5 utilisés.

Dans le mode de réalisation considéré, le diamètre final des bumps 5 après montage est de 150 $\mu$m.

Le boîtier BGA 4 comporte un écran de blindage 6. Cet écran de blindage 6 est une couche métallique de bonne conductivité électrique, par exemple en cuivre, du boîtier BGA 4 (par exemple la couche 1 du boîtier BGA) s'étendant dans un plan P2 parallèle au plan P1 de l'inductance 3 et disposée face à l'inductance 3. L'écran de blindage 6 décrit par exemple un rectangle dans le plan P2. Les dimensions de l'écran de blindage 6 sont telles que la projection de l'écran de blindage 6 sur le plan P1 contient entièrement l'inductance 3. Sur la figure 2 est représentée la projection orthogonale PO6 de l'écran de blindage 6 sur le plan P1 de l'inductance 3.

L'écran de blindage 6 est relié à la masse du circuit à puce 1. La distance z1 entre les plans P1 et P2 est inférieure à 500 $\mu$m. Dans un mode de mise en oeuvre avantageux, z1 est inférieur à 300 $\mu$m.

L'écran de blindage 6 intercepte, à la place de l'inductance 3 du VCO, les lignes de champs électromagnétiques rayonnées depuis des composants intégrés sur la puce 2.

Dans le mode de réalisation considéré, le circuit à puce 1 comprend en outre un second support 7, parallèle au boîtier 4, et qui assure comme ce dernier une fonction de maintien. Le second support 7 est par exemple une carte électronique standard (PCB, "Printed Circuit Board"). La carte PCB 7 est fixée à l'ensemble constitué du boîtier BGA 4 et de la puce 2 à l'aide de billes de soudure ou "bumps" 8 disposées entre le PCB 7 et le boîtier BGA 4, ces bumps 8 reliant électriquement ces deux éléments.

La distance de la puce 2 à la carte PCB 7 est déterminée par le diamètre des bumps 8 utilisés. Dans le mode de réalisation considéré, le diamètre final des bumps 8 après montage est de 500 microns.

Un second écran de blindage 9 est réalisé par une couche métallique du PCB 7. Il est relié à la masse du circuit à puce 1.

L'écran de blindage 9 s'étend dans un plan P3 parallèle au plan P1 de l'inductance 3. Il est disposé de telle sorte que sa projection orthogonale sur le plan P1 inclut l'inductance 3.

La distance z2 ente les plans P1 et P3 est inférieure à 500 $\mu$m. Dans un mode de réalisation avantageux, z2 est inférieur à 300 $\mu$m.

Des simulations ont été effectuées pour un circuit à puce 1' représenté en perspective en figure 3 et similaire à celui représenté en figure 1. A la figure 3, un élément correspondant à un élément de la figure 1 qui porte la référence X, porte la référence X'.

Le circuit à puce 1' comprend une puce 2' qui intègre un VCO avec une inductance 3'. La puce 2' considérée pour ces mesures, intègre en outre une autre inductance 3" formée dans le substrat dans le plan P'1 à une distance D de l'inductance 3'.

Des écrans de blindage 6' et 9' similaires aux écrans 6 et 9 décrits en référence à la figure 1 ont été disposés de part et d'autre de P1. Dans le mode de réalisation représenté en figure 3, les projections orthogonales des écrans 6' et 9' sur le plan P1 incluent les deux inductances 3' et 3".

On considère ci-après les effets parasites provoqués par le rayonnement magnétique de l'inductance 3" sur le fonctionnement de l'inductance 3', et l'atténuation apportée par l'invention sur ce champ magnétique parasite subi par l'inductance 3'.

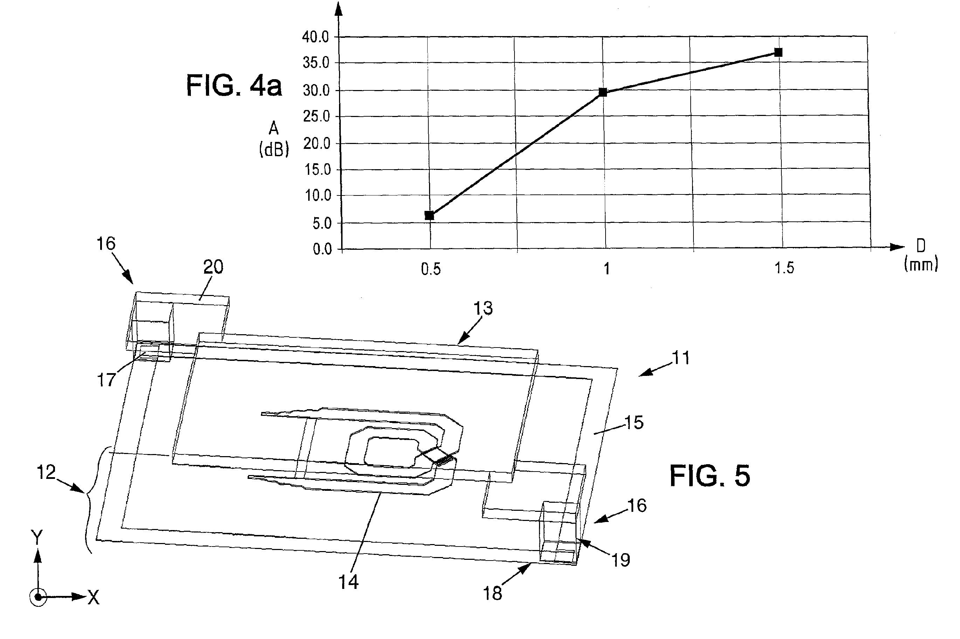

Cette atténuation A est représentée en figure 4a. En ordonnées est représenté l'atténuation A(H) exprimée en décibel (dB), H étant le champ magnétique parasite subi par l'inductance 3' avant la mise en place des écrans de blindage 6' et 9' selon l'invention, et H' étant le champ magnétique subi par l'inductance 3' après cette mise en place, l'atténuation A(H) est égale à 20xlog $\frac{H'}{H}$.

En abscisses est représentée la distance D entre les inductances 3' et 3", en millimètres (mm).

Les valeurs indiquées pour l'atténuation correspondent à une distance z1=100$\mu$m et une distance z2=300$\mu$m, à des valeurs d'inductances 3' et 3" de 1 nanoHenry (nH), et à une fréquence de fonctionnement de la puce de 3,6 GHz.

Ainsi, un blindage 6' situé à z1=100$\mu$m au-dessus des inductances 3' et 3" et un blindage 9' situé à z2=300$\mu$m en-dessous de celles-ci apportent, lorsque la distance D entre l'inductance 3' perturbée et l'inductance 3" perturbatrice est égale à 1mm, une atténuation de 30dB au champ magnétique parasite (à H2). Le plan patterné selon l'art antérieur n'apportait que quelques décibels d'atténuation au champ magnétique parasite. Les écrans 6' et 9' de blindage selon l'invention apportent en outre une atténuation A(E) de 26 dB pour le champ électrique parasite E, pour D=1 mm.

Par ailleurs, ils introduisent, pour D=1mm, une dégradation de la valeur de l'inductance 3' d'environ -6,5%, et sur son facteur de qualité Q d'environ - 4,3%.

Les écrans de blindage considérés ci-dessus ont été réalisés dans un boîtier BGA et une carte PCB. D'autres modes de réalisation peuvent être implémentés.

Par exemple, un premier écran de blindage peut être réalisé sur un premier support du circuit à puce sur lequel la puce est fixée par soudure, par exemple un support de type IPAD ("Integrative Passive and Active Device"). Un second écran peut être réalisé dans ce cas sur un second support du circuit à puce, par exemple un boîtier BGA, l'inductance étant prise en sandwich entre les deux écrans. Un tel circuit à puce est destiné à être fixé sur un circuit intégré par l'intermédiaire de billes de soudure entre le boîtier BGA et le circuit imprimé.

La distance entre le plan de l'inductance et les plans des écrans extérieurs à la puce selon l'invention est au maximum de 500 μm, sinon le blindage n'est pas efficace.

A titre d'illustration, sur la figure 4b est représentée l'atténuation A(H) (telle que définie ci-dessus en référence à la figure 4a) en fonction de la distance Z exprimée en micromètre (μm) entre le plan de l'inductance et chacun des plans des écrans de blindage d'un circuit à puce similaire à celui représenté en figure 3. Ces plans des écrans de blindage sont équidistants du plan de l'inductance (Z = z1 = z2) Les valeurs indiquées pour l'atténuation correspondent à des valeurs d'inductances 3' et 3" de 1 nanoHenry (nH), à une distance entre les inductances 3' et 3" de 1 mm et à une fréquence de fonctionnement de la puce de 3,6 GHz.

La distance entre le plan de l'inductance et le plan de chacun des écrans extérieurs à la puce selon l'invention est au minimum de 100 μm. Sinon, le champ magnétique généré par l'inductance serait perturbé trop fortement et le facteur de qualité de l'inductance serait dégradé trop fortement.

Sur la figure 5 est représenté en perspective un circuit à puce 11 dans un deuxième mode de réalisation de l'invention. Ce circuit à puce comprend une puce 12. Il comporte en outre un premier écran de blindage 13 réalisé à l'extérieur de la puce 12. Il s'agit par exemple de la première couche métal d'un boîtier BGA similaire à l'écran de blindage 6 représenté en figure 1 et relié à la masse.

La puce 12 comporte une inductance 14 sensiblement plane formée sur la couche 5 du substrat.

La puce 12 comporte en outre un écran de blindage 15 situé dans le silicium et formé en couche métal 2 du substrat de la puce 12 et s'étendant parallèlement au plan de l'inductance 14. L'écran de blindage 15 décrit une forme sensiblement annulaire, de dimensions telles que sa projection orthogonale sur le plan de l'inductance 14 entoure celle-ci.

Par ailleurs, l'écran de blindage 13 à l'extérieur de la puce 12 et l'écran de blindage 15 formé dans le substrat de la puce 12 sont mis en contact électrique par l'intermédiaire de connexions 16.

Dans le mode de réalisation représenté à la figure 5, ces connexions 16 sont au nombre de deux et comportent chacune une connexion électrique entre la couche 2 et la couche 5 de la puce 12 consistant en un cylindre de métal vertical dans le silicium, encore appelé via 17. Chaque connexion 16 comporte en outre sur la couche 5 de la puce un pavé de métal ou plot ("pad" en anglais) 18 en contact avec le via 17. Ce plot 18 sert de base d'appui à une boule de métal ou Bump 19 permettant de relier électriquement le plot 18 à une plaque de métal 20 située dans le plan de l'écran de blindage 13 et en contact avec ce dernier.

Les dimensions, sous la forme (XxYxZ) sont par exemple (40μm×40μm×6,71 μm) pour le via 17, (80μm×80μm×2,5μm) pour le plot 18 et (80μm×80μm×100μm) pour le Bump 19.

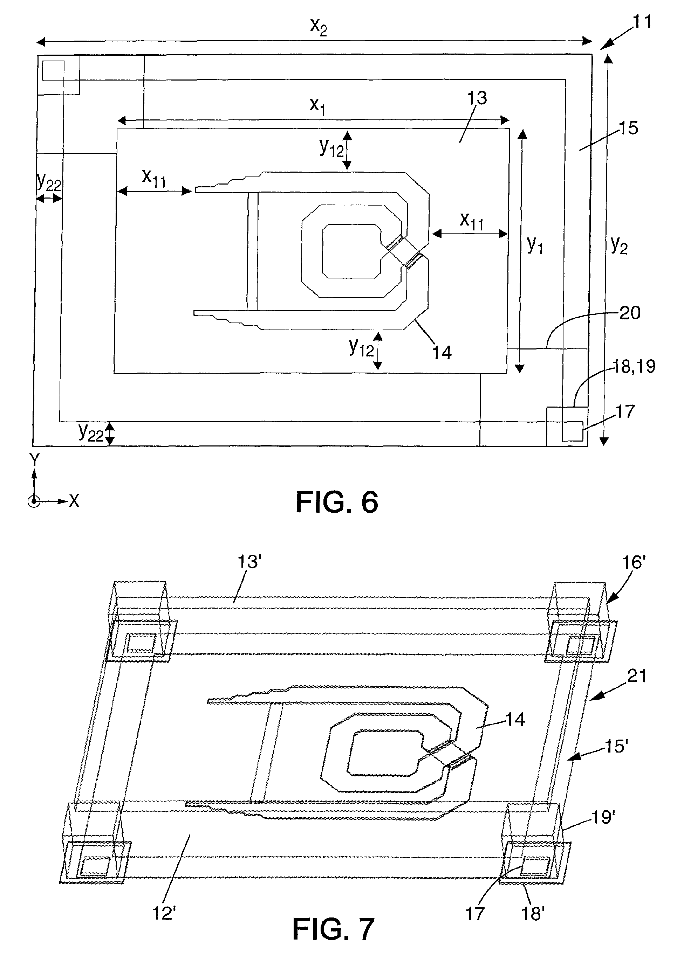

La figure 6 représente une vue de dessus du circuit à puce 11 représenté en figure 5.

L'inductance est centrée par rapport aux projections orthogonales des deux écrans de blindage 13 et 15 sur le plan de l'inductance 14.

La couronne décrite par l'écran 15 a une épaisseur de y22=0,05mm, un encombrement en longueur x2 de 1,05mm et un encombrement en largeur y2 de 0,8mm. L'écran de blindage 13 a une longueur x1 de 0,75mm et une largeur y1 de 0,5mm.

Avec ces dimensions, la projection orthogonale de l'écran 13 sur le plan 14 de l'inductance comprend cette dernière et la dépasse en longueur de part et d'autre de x11=0,15mm, et en largeur de part et d'autre dey1 2=0,09mm.

La projection orthogonale de l'écran 15 sur le plan de l'inductance dans l'exemple considéré dépasse ainsi en longueur l'inductance de part et d'autre de 0,25 mm.

Dans un autre mode de réalisation, x11 et y12 toutes deux sont supérieures ou égales à 0,15 mm.

Dans un autre mode de réalisation, la projection orthogonale de l'écran 15 sur le plan de l'inductance dans l'exemple considéré dépasse ainsi en largeur l'inductance de part et d'autre de 0,25 mm.

Dans le mode de réalisation représenté en perspective en figure 7, un circuit à puce 21 comportant une puce 12' est similaire à celui représenté en figure 5, si ce n'est qu'à la place des deux connexions électriques 16 entre les écrans de blindage 13 et 15, le circuit à puce 21 comporte quatre connexions électriques 16' entre deux écrans 13' et 15' similaires aux écrans 13 et 15. Chaque connexion 16' comprend un via 17 de dimensions (40μm×40μm×6,71μm), un plot 18' de dimension (100μm×100μm×2,5μm) et un Bump 19' reliant directement le plot 18' et l'écran de blindage 13.

Le nombre de connections entre un écran de blindage dans le substrat et un écran de blindage hors de la puce, les deux écrans s'étendant parallèlement au plan de l'inductance et la prenant en sandwich, permet d'ajuster les effets du blindage aux parasites réalisé.

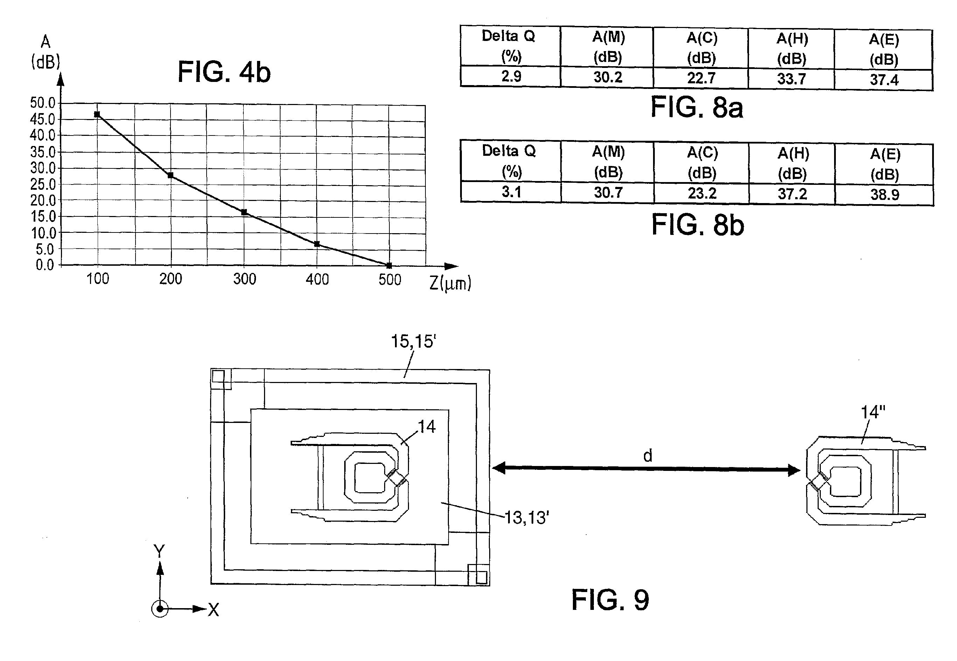

La figure 8a, et la figure 8b, donnent un tableau illustrant les effets à H2 d'un blindage conforme au mode de réalisation de la figure 6 avec deux connections, respectivement de la figure 7 avec quatre connections, en fonction des différentes formes de couplage électromagnétique entre l'inductance sensible 14, et une inductance perturbatrice 14" située sur la même puce 12 dans le plan de l'inductance 14, à même coordonnée selon l'axe X, à l'extérieur de la projection orthogonale de l'écran de blindage 15,15', et tel que la distance selon l'axe Y entre la bobine perturbatrice et le côté le plus proche de l'écran de blindage 15, 15' est égale à d=1mm, comme représenté en figure 9.

Les atténuations considérées du couplage entre les deux inductances sont celles portant sur l'inductance mutuelle M, la capacitance mutuelle C, le champ magnétique H et le champ électrique E, soit A(M), A(C), A(H), A(E). Par ailleurs, les variations "Delta Q" du facteur de qualité Q de l'inductance 14 apportées par les écrans de blindage figurent également dans ces tableaux.

On ajuste les distances relatives entre le plan de l'inductance et les plans respectifs du ou des écrans de blindage selon l'invention, en fonction de la géométrie de l'inductance à blinder, de la distance entre perturbateur et perturbé, de l'atténuation que l'on souhaite apporter par le blindage, de la dégradation des caractéristiques de l'inductance que l'on tolère (valeur de l'inductance et facteur de qualité).

On peut toutefois prendre avantageusement les distances indiquées ci-dessous.

Dans le cas d'un ou deux écran(s) de blindage situé(s) hors du silicium, la distance entre cet écran ou ces écrans et le plan de l'inductance est comprise entre 100µm et 300µm.

Dans le cas où en plus d'un écran de blindage hors de la puce, on dispose un écran de blindage dans le silicium, cet écran dans le silicium dernier se trouvera avantageusement à une distance inférieure à 30 µm du plan de l'inductance. Dans le cas de la technologie silicium considérée dans la présente description, cette distance sera choisie avantageusement égale à 2,5µm sous l'inductance.

Dans le cas où en plus d'un écran de blindage hors de la puce, on dispose un écran de blindage dans le silicium, cet écran dans le silicium se trouvera avantageusement à une distance minimale de l'inductance de 100 µm, dans le plan défini par les axes X et Y.

Un blindage selon l'invention d'une inductance sensible qu'on souhaite protéger des rayonnements perturbateurs d'un composant présent également sur la puce est particulièrement efficace lorsque la distance, dans le plan de l'inductance, entre l'inductance et le composant perturbateur est supérieure ou égale à 0,5 mm. Une distance égale ou supérieure à 1 mm par exemple convient tout à fait.

Ainsi l'invention permet de mettre en place un blindage en champ proche pour une inductance (i.e. on réalise une protection vis-à-vis d'un perturbateur situé dans la même puce). Le blindage réalisé est efficace non seulement en champ électrique, mais également en champ magnétique. On utilise des structures métalliques existantes, dans les supports du circuit à puce (boîtier, module, PCB), ce qui minimise le coût de l'opération. Les dégradations apportées aux performances de l'inductance à protéger (valeur d'inductance et facteur de qualité) sont préservées.

## Revendications

**1.** Circuit à puce (1;1';11) comportant une puce (2;2'; 12), ladite puce comportant au moins un substrat semi-conducteur, des composants sensiblement plans formés sur ledit substrat parmi lesquels figurent au moins un composant émetteur (3") 'apte à émettre des rayonnements électromagnétique et une inductance (3;3';14) sensible à des rayonnements électromagnétiques incidents, et au moins un premier écran de blindage (6;6';13) extérieur à la puce, s'étendant parallèlement au plan (P1) de l'inductance (3;3';14), **caractérisé en ce que** ledit premier écran de blindage est disposé en regard de ladite inductance à une distance inférieure à environ 500 micromètres, permettant ainsi d'assurer un blindage de l'inductance sensible vis-à-vis du composant émetteur en préservant le facteur qualité de l'inductance.

**2.** Circuit à puce selon la revendication 1, dans lequel la distance (z1) entre le plan (P1) de l'inductance et le premier écran de blindage (6;6';13) est supérieure ou égale à 100 micromètres.

**3.** Circuit à puce selon la revendication 1 ou la revendication 2, dans lequel la distance entre l'inductance sensible et le composant émetteur est supérieure à 1 millimètre.

**4.** Circuit à puce (1;1';1") selon l'une quelconque des revendications 1 à 3, dans lequel la projection orthogonale (PO6) du premier écran de blindage (6) sur le plan (P1) de l'inductance (3) inclut entièrement ladite inductance.

**5.** Circuit à puce (1;1';1") selon la revendication 3, dans lequel la projection orthogonale (PO6) du premier écran de blindage (6) sur le plan (P1) de l'inductance (3) dépasse au moins un des bords de l'inductance d'au moins 150 microns.

6. Circuit à puce selon l'une quelconque des revendications précédentes, dans lequel la puce (2) s'étend parallèlement à un premier support (4), la distance de la puce au premier support étant déterminée par le diamètre d'un premier type de bumps (5) utilisés pour relier électriquement la puce au premier support, ledit premier écran de blindage étant réalisé dans le premier support.

7. Circuit à puce selon l'une quelconque des revendications précédentes, comportant en outre un second écran de blindage (9;9'), s'étendant parallèlement au plan (P1) de l'inductance (3;3';14) et disposé en regard de ladite inductance à une distance comprise entre 100 et 500 micromètres, les premier et second écrans de blindage se trouvant de part et d'autre de l'inductance.

8. Circuit à puce selon la revendication 6 et la revendication 7, dans lequel le circuit à puce comporte en outre un second support (7) parallèle au premier support (4), les premier et second supports étant situés de part et d'autre de la puce (2), la distance de la puce au second support étant déterminée par le diamètre d'un second type de bumps (8) utilisés pour relier électriquement le premier support au second support et ledit second écran de blindage étant réalisé dans le second support.

9. Circuit à puce selon la revendication 6, **caractérisé en ce que** le diamètre final du premier type de bumps est de 150 microns.

10. Circuit à puce selon la revendication 8 ou la revendication 9, **caractérisé en ce que** le diamètre final du second type de bumps est de 500 microns.

11. Circuit à puce (11;21) selon l'une quelconque des revendications 1 à 6, comportant en outre un second écran de blindage (15;15') s'étendant parallèlement au plan (P1) de l'inductance (3;3';14) et disposé en regard de ladite inductance, les premier et second écrans de blindage se trouvant de part et d'autre de l'inductance, dans lequel ledit second écran a une forme annulaire et dans lequel la projection orthogonale du second écran de blindage (15;15') sur le plan de l'inductance (14) entoure ladite inductance.

12. Circuit à puce (11;21) selon la revendication 11, dans lequel la distance entre le plan (P1) de l'inductance et le second écran de blindage (15 ;15') est inférieure ou égale à 30 microns.

13. Circuit à puce (11;21) selon l'une des revendications 11 ou 12, dans lequel la projection orthogonale du second écran de blindage (15) sur le plan (P1) de l'inductance (3) dépasse au moins un des bords de l'inductance de 0,25 mm.

14. Circuit à puce (11;21) selon l'une quelconque des revendications 11 à 13, dans lequel le second écran de blindage (15;15') est formé sur le substrat de la puce (12;12').

15. Circuit à puce l'une quelconque des revendications précédentes, dans lequel la puce comprend un VCO, et l'inductance sensible est un élément du VCO.

**FIG. 1**

**FIG. 2**

**FIG. 3**

EP 1 553 812 A2

## FIG. 4a

## FIG. 5

FIG. 6

FIG. 7

| Delta Q (%) | A(M) (dB) | A(C) (dB) | A(H) (dB) | A(E) (dB) |
|---|---|---|---|---|
| 2.9 | 30.2 | 22.7 | 33.7 | 37.4 |

FIG. 8a

| Delta Q (%) | A(M) (dB) | A(C) (dB) | A(H) (dB) | A(E) (dB) |
|---|---|---|---|---|
| 3.1 | 30.7 | 23.2 | 37.2 | 38.9 |

FIG. 8b

FIG. 4b

FIG. 9